Europäisches Patentamt

European Patent Office

Office européen des brevets

(11) Numéro de publication : **0 313 431 B1**

(12) **FASCICULE DE BREVET EUROPEEN**

(45) Date de publication du fascicule du brevet :
18.03.92 Bulletin 92/12

(51) Int. Cl.$^5$ : **G11C 16/04**

(21) Numéro de dépôt : **88402522.2**

(22) Date de dépôt : **05.10.88**

(54) **Procédé de programmation des cellules mémoire et circuit pour la mise en oeuvre de ce procédé.**

(30) Priorité : **19.10.87 FR 8714343**

(43) Date de publication de la demande :
**26.04.89 Bulletin 89/17**

(45) Mention de la délivrance du brevet :
**18.03.92 Bulletin 92/12**

(84) Etats contractants désignés :
**DE ES GB IT NL**

(56) Documents cités :
**EP-A- 0 104 657**
**EP-A- 0 114 504**
**EP-A- 0 154 379**

(73) Titulaire : **SGS-THOMSON MICROELECTRONICS S.A.**
**7, Avenue Galliéni**
**F-94250 Gentilly (FR)**

(72) Inventeur : **Chevalier, Christophe**
**Cabinet Ballot-Schmit 84, Avenue Kléber**
**F-75116 Paris (FR)**
Inventeur : **Kowalski, Jacek,Cabinet Ballot-Schmit**
**84,Avenue Kleber**
**75116 Paris (FR)**

(74) Mandataire : **Ballot, Paul Denis Jacques et al**
**Cabinet Ballot-Schmit 7, rue le Sueur**
**F-75116 Paris (FR)**

EP 0 313 431 B1

Jouve, 18, rue Saint-Denis, 75001 PARIS

**Description**

La présente invention a pour objet un procédé de programmation des cellules mémoire d'une mémoire ainsi qu'un circuit pour la mise en oeuvre de ce procédé. Elle concerne tout particulièrement les mémoires dont les cellules mémoire comportent des transistors à grille flottante et dont la programmation est obtenue par un effet de champ électrique. Il s'agit plus particulièrement des mémoires de type EEPROM par opposition aux mémoires dites EPROM, dont la programmation des cellules mémoire passe par une mise en saturation du canal de conduction du transistor à grille flottante qui sert d'organe de mémorisation à ces cellules mémoire. Dans une application particulière, le procédé de programmation est plus particulièrement utilisé en "mode de page". Dans un tel mode on exécute en même temps la programmation de plusieurs cellules mémoire raccordées à une même ligne de mot du plan mémoire. En outre l'invention est plus particulièrement destinée aux opérations de programmation pour lesquelles des tensions élevées sont mises en jeu.

Dans l'état de la technique, la programmation du transistor à grille flottante d'une cellule mémoire de type EEPROM s'obtient en soumettant les régions drain et source de ce transistor à un potentiel élevé par rapport à un potentiel auquel est soumise la grille de commande de ce transistor, superposée à la grille flottante. La grille flottante possède,dans ce but de programmation, un pion d'amorçage qui permet localement, au droit de ce pion, d'augmenter la valeur du champ électrique induit par cette différence de potentiel. Sous l'effet de ce champ électrique de programmation, des particules, des électrons, quittent la grille flottante. Lorsqu' ultérieurement le transistor de cette cellule mémoire est normalement sollicité, en alimentation et en commande, il reste conducteur ou se bloque selon qu'il a ou non été programmé par les migrations des électrons. La programmation d'un transistor passe donc par la soumission d'au moins une de ses régions, et nécéssairement de celle qui est proche du pion d'amorçage, à une tension élevée VPP. L'effacement de cette programmation s'obtient en appliquant la tension élevée Vpp sur la grille de commande et une tension basse sur une des régions (sur le drain).

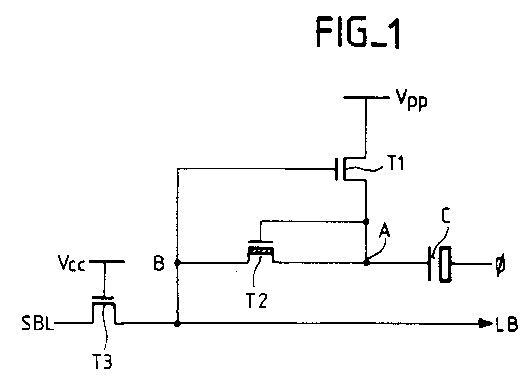

En pratique, si la tension d'alimentation d'un circuit intégré de type EEPROM est de l'ordre de 5 volts, VPP est de l'ordre de 20 volts. Ces circuits de type EEPROM, notamment dans des applications de cartes à mémoire avec circuit intégré, sont généralement munis de générateurs internes pour l'élaboration du potentiel VPP. Ces générateurs, qui peuvent par exemple comporter des multiplicateurs de type SHENKEL, ne peuvent supporter, à ces hautes tensions, de consommation statique dépassant quelques microampères. Pour pouvoir permettre la programmation, on a coutume d'assister ces générateurs, en tous les endroits où ils distribuent leur potentiel élevé, par des pompes de charge. Une pompe de charge comporte essentiellement, selon la figure 1, un transistor T1 relié d'une part au générateur de potentiel VPP et d'autre part, au point A, à une capacité C. Un transistor natif T2 (à tension de seuil VT = 0) est relié d'une part à la borne A et d'autre part, par une borne B, à la grille de commande du transistor T1. A l'autre borne de la capacité A on introduit un signal impulsionnel variant entre VCC et zéro à un rythme élevé : par exemple un signal d'horloge à 5 Mhz. La grille de commande du transistor T2 est reliée au point A. Un troisième transistor T3, dont la grille de commande est reliée au potentiel VCC, reçoit d'une part un signal SBL marquant, selon son état, l'intention de programmer un point mémoire. D'autre part le transistor T3 est raccordé au point B. Le point B est en outre raccordé à une ligne de bits LB qui aboutit aux régions source des transistors à grille flottante des cellules mémoire à programmer.

Si une ligne de bits ne doit pas être sélectionnée, par exemple parce qu'aucune des cellules mémoire qui y est raccordée ne doit être programmée, le signal SBL vaut zéro. Si le signal SBL vaut zéro, le transistor T3 est en court-circuit, le point B et la ligne de bits sont à potentiel nul, la pompe de charge formée de la capacité C et le transistor T2 débite inutilement, mais le transistor T1 est bloqué. Par contre si la ligne de bits est sélectionnée, si SBL vaut VCC, on va montrer que le potentiel disponible sur la ligne de bits monte à VPP. Plus exactement elle monte à VPP + VT, VT étant la tension de seuil du transistor T1. Supposons par exemple, lorsque le signal impulsionnel PHI (∅) est à zéro, que A vaut sensiblement VCC. Dans ces conditions, du fait que le transistor T2 est natif, B vaut aussi sensiblement VCC. En conséquence le transistor T3 est bloqué. Le transistor T1 est au départ également bloqué. Lorsque le signal PHI monte à VCC, la capacité C transmet un échelon de tension, et le potentiel de A monte : par exemple de 2 volts. Dans ces conditions le transistor T2 se met à conduire et le potentiel en B suit le potentiel en A. Lorsque le signal PHI revient à zéro, A subit une chute de tension qui bloque le transistor T2, mais qui rend le transistor T1 conducteur. Tandis que le potentiel de B reste à la valeur qu'il venait d'atteindre, et que le potentiel de A avait décru, la mise en conduction du transistor T1 impose au potentiel de A de croître. Le potentiel de A croît sensiblement jusqu'à la valeur du potentiel de B moins la chute de tension grille- source dans le transistor T1. Par exemple on peut admettre qu'ainsi A a gagné un volt, et est passé à 6 volts, par rapport à sa situation antérieure. Ainsi de suite, au rythme des impulsions PHI, le potentiel de A et le potentiel de B croissent jusqu'à VPP (+VT). En effet lorsque le potentiel en B atteint VPP + VT, le noeud A, chargé à chaque impulsion montante de PHI, se décharge dans l'alimentation VPP par le transistor T1. Lorsque le potentiel de B a atteint un niveau suffisant, la programmation du transistor à grille flottante du point mémoire s'exécute.

L'inconvénient présenté par l'existence des pompes de charge est particulièrement ressenti lorsque la programmation de la mémoire est faite en mode de page, c'est à dire lorsqu'on cherche à programmer tous les bits appartenant à un même mot, c'est à dire appartenant à des lignes de bits différentes. La programmation en mode de page est en elle-même intéressante parce qu'elle permet d'accéder à plusieurs cellules mémoire du plan mémoire en même temps. En effet , plutôt que d'exécuter la programmation des cellules mémoire les unes après les autres il est préférable, pour diminuer le temps de programmation rapporté à un bit, et dans la mesure où les cellules mémoire sont distribuées aux intersections de lignes de bits et de lignes de mot, de sélectionner un ensemble de lignes de bits d'une part, et de sélectionner ensuite d'autre part une ligne de mot pour programmer en même temps toutes les cellules mémoire qui appartiennent à ces lignes de bits et à cette ligne de mot. Il suffit ensuite de changer la ligne de mot pour pouvoir accéder à un nouvel ensemble de cellules mémoire appartenant à ces lignes de bits et à cette nouvelle ligne de mot.

De par son principe la programmation en mode de page impose que des pompes de charge doivent être affectées à chaque ligne de bits du plan mémoire. En effet, lorsque des cellules mémoire dans une ligne de bits doivent être programmées la ligne de bits concernée est sélectionnée, son transistor T3 est bloqué. Par contre les cellules mémoire quine doivent pas être programmées sont placées sur des lignes de bits qui, en correspondance, ne doivent pas être sélectionnées: leur transistor T3 doit être passant. Si toutes les lignes de bits étaient reliées à une même pompe de charge, celle-ci débiterait dans les transistors passant des lignes de bits non sélectionnées, et le potentiel d'aucune des lignes de bits ne monterait jusqu'à VPP. La complexité des pompes de charge et surtout l'encombrement qu'elles provoquent, la place qu'elles occupent en mémoire, sont des facteurs négatifs pour l'aptitude à l'intégration des circuits de type EEPROM.

L'invention a pour objet de remédier à ces inconvénients en supprimant l'existence, au moins pour une grande partie, des pompes de charge, tout en autorisant dans une version préférée le fonctionnement en programmation en mode de page. Dans l'invention on tire parti du fait que la programmation des cellules d'une mémoire de type EEPROM s'obtient sans consommation de courant sur le potentiel VPP du fait que cette programmation est provoquée par un effet de champ électrique. Dans le procédé de l'invention, avant la programmation, on neutralise la sélection des lignes de bits et pendant cette neutralisation, on pré-charge toutes les lignes de bits à un potentiel élevé. Ensuite on sélectionne les lignes de bits, en supprimant la neutralisation. Le potentiel des lignes de bits non sélectionnées s'écroule naturellement par leur transistor T3 passant. Le potentiel des lignes de bits sélectionnées ne s'écroule pas parce que, la pré-charge etant terminée, toutes les lignes sont alors découplées de leur alimentation à VPP qui elle peut s'écrouler. Enfin, pour la programmation, on impose sur les grilles de commande des transistors à grille flottante des cellules mémoire à programmer un potentiel nul. Dans ces conditions, seuls ces transistors se programment. Il est à remarquer que ces transistors n'ont pas été programmés au moment de la pré-charge parce qu'à ce moment des transistors d'accès aux cellules sont bloqués. Ils sont bloqués par une commande appliquée sur leur grille de commande. Dans une variante préférée, plutôt que de sélectionner les grilles de commande des transistors des cellules mémoire à programmer les unes à la suite des autres, on sélectionne en même temps, puis on impose un potentiel faible en même temps, sur toutes les grilles de commande des transistors reliés à une même ligne de mot. On programme ainsi la mémoire en mode de page.

L'invention a en conséquence pour objet un procédé de programmation des cellules mémoire d'une mémoire, ces cellules mémoires comportant des transistors à grille flottante programmables par effet du champ électrique, procédé dans lequel
    – on sélectionne les cellules à programmer puis,
    – on programme les cellules sélectionnées par application de potentiel de programmation, caractérisé en ce que
    – avant la programmation, on neutralise la sélection des cellules en découplant les drains des transistors à grille flottante de tous les potentiels, et
    – on pré-charge ces cellules en leur appliquant aux-dits drains certains des potentiels de programmation, puis
    – on arrête la neutralisation, et
    – on programme ces cellules en leur appliquant les autres potentiels de programmation.

L'invention concerne également un circuit de programmation des transistors à grille flottante de cellules mémoire d'une mémoire, comportant des moyens pour appliquer des potentiels de programmation sur les bornes de ces transistors, caractérisé en ce qu'il comporte un circuit de neutralisation de la sélection des cellules qui découple, avant la programmation, les drains des transistors à grille flottante de tous les potentiels et un circuit de pré-charge d'au moins un de ces potentiels de programmation sur les-dits drains pendant la période de neutralisation.

L'invention sera mieux comprise à la lecture de la description qui suit et à l'examen des figures qui l'accompagnent. Celles-ci ne sont données qu'à titre indicatif et nullement limitatif de l'invention. Les figures montrent :

– figure 1 : la représentation d'une pompe de charge selon l'état de la technique cité ;

– figure 2 : la représentation schématique d'un circuit pour la mise en oeuvre du procédé de programmation selon l'invention ;

– figures 3a à 3g : des diagrammes temporels de signaux utilisés dans le procédé de l'invention.

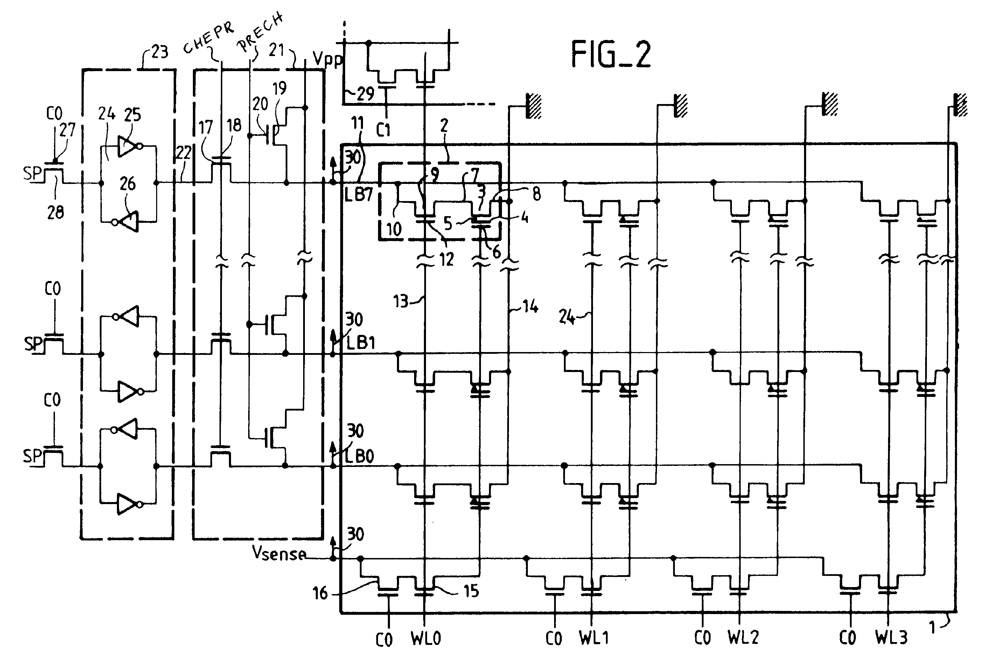

La figure 2 représente un circuit pour la mise en oeuvre du procédé de l'invention. Une mémoire 1 comporte des cellules mémoire telles que 2 comportant un transistor 3 à grille flottante comme organe de mémorisation . Ce transistor 3 comporte un grille flottante 4 munie d'un pion d'amorçage 5, une grille de commande 6 superposée à la grille flottante 4, un drain 7, et une source 8. Le transistor à grille flottante de chaque cellule mémoire est en série par son drain 7 avec la source d'un transistor d'accès 9, dont le drain 10 est relié à une ligne de bits 11, et dont la grille de commande 12 est reliée à une ligne de mot 13. La source du transistor 3 est reliée à une connexion dite de masse de réseau 14. La grille de commande 6 du transistor à grille flottante 3 est commandée par un signal VSENSE acheminé par un transistor de contrôle de commande 15 en série avec un transistor de pilotage 16. Le transistor 15 de contrôle de commande reçoit sur sa grille de commande, en commun avec toutes les grilles de commande 12 des transistors d'accès 9 aux transistors des cellules mémoire, un signal WLi de sélection d'une ligne de mot transmis par la ligne de mot : un signal WLO pour la ligne de mot 13. Le transistor de pilotage reçoit une commande de pilotage Cj. Lorsque Cj et WLi sont portés à un potentiel élevé, par exemple VPP, le potentiel VSENSE est appliqué sur toutes les grilles de commande des transistors à grille flottante des cellules mémoire commandées par un même signal de sélection de ligne de mot et de commande de pilotage.

Dans l'invention, essentiellement, on neutralise, avant la programmation, au moyen d'un signal de neutralisation CHEPR la sélection des lignes de bits telles que 11 aboutissant à des cellules mémoire à programmer. Dans ce but, chaque ligne de bits est en série avec un interrupteur, en pratique un transistor tel que le transistor 17 qui reçoit sur sa grille de commande 18 le signal CHEPR. Cette neutralisation est complétée par une non sélection de toutes les lignes de mot : un potentiel nul est appliqué comme signal de sélection de ligne de mot WLi et/ou comme signal de commande de pilotage Cj pour toutes les lignes de mot intéressées par les lignes de bits à précharger. Il en résulte que les potentiels appliqués sur toutes les grilles de commande 6 des transistors à grille flottante 3 sont en l'air. En conséquence ces transistors ne conduisent pas d'une part, et ne se programment pas d'autre part, pendant cette neutralisation.

Pendant que la neutralisation est effective on effectue la pré-charge des lignes de bits aboutissant aux cellules mémoire à programmer. Cette pré-charge est effectuée en appliquant au moyen d'une série d'interrupteurs tels que 19 un potentiel élevé de programmation VPP fourni par exemple par un générateur de type connu. Ce générateur peut n'avoir que des qualités de débit de courant faible. Dans la pratique les interrupteurs 19 peuvent être des transistors dont la grille de commande 20 reçoit un signal de pré-charge PRECH qui commande la connexion de la tension de programmation VPP aux lignes de bits.

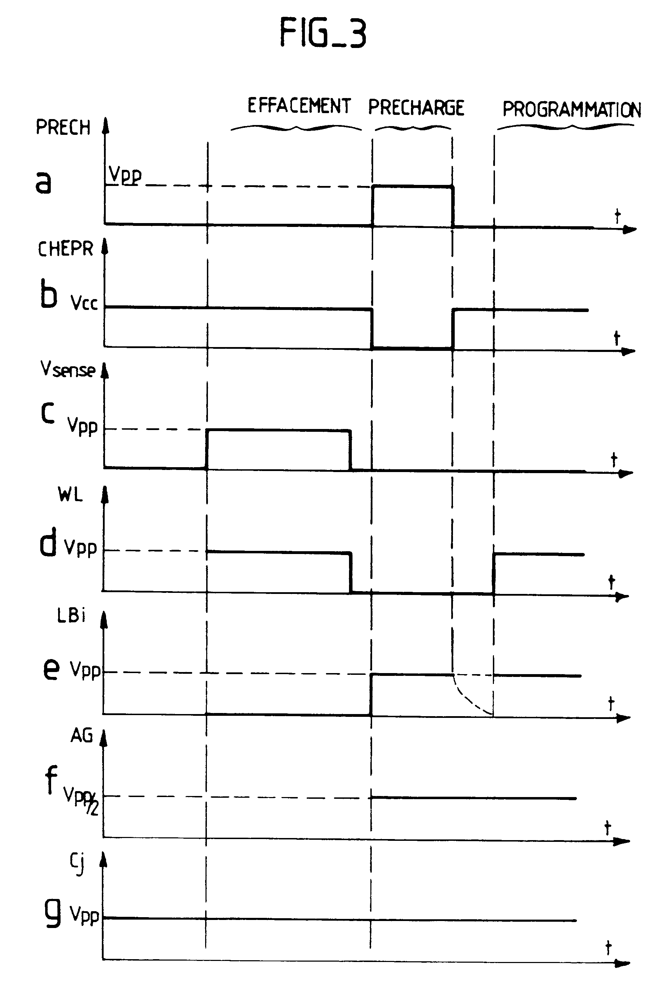

Sur la figure 3, les diagrammes 3a à 3g montrent respectivement les potentiels atteints par les signaux respectivement de pré-charge PRECH et de son complémentaire CHEPR, VSENSE, WLi, Bi, AG, et Cj. On observe que pendant la pré-charge le signal de pré-charge est à un potentiel élevé, à VPP, pour rendre les transistors tels que 19 conducteurs jusquà ce que les lignes de bits auxquelles ils sont raccordés atteignent le potentiel de programmation VPP. Pendant cette pré-charge les signaux (CHEPR) de neutralisation des lignes de bits et de sélection (WLi ou Cj) des cellules sont à zéro. Les transistors tels que 17 sont donc ouverts, les lignes de bits ne peuvent pas se décharger. On observe d'ailleurs que pendant cette pré-charge les signaux WLi sont tous nuls de même que, par précaution, le signal VSENSE. Le signal Cj (figure 3g) n'est pas porté à zéro, les transistors 16 sont passants, mais celà n'a pas d'importance puisque les transistors 15 en série sont ouverts. En conséquence les grilles de commande 6 des transistors à grille flottante 3 sont quand même en l'air. Pour des raisons que l'on étudiera ultérieurement le signal AG appliqué sur les connexions de masse de réseau 14 est pendant cette pré-charge, et jusqu'a la fin de la programmation, porté à un potentiel intermédiaire : par exemple VPP/2. De cette neutralisation de la sélection des lignes de bits et de cette pré-charge, il résulte que toutes les lignes de bits concernées par un circuit de pré-charge 21 contenant des transistors 17 et 19 activés seront portées à un potentiel VPP.

Pendant l'opération de programmation (figure 3) , on va appliquer sur les grilles de commande des cellules mémoire 3 à programmer un potentiel nul. Ce potentiel nul est fourni par le signal VSENSE qui vaut zéro pendant la phase de programmation et qui est transmis par les transistors de pilotage 16 et de contrôle de commande 15. Pendant la programmation les signaux Cj et WLi appliqués respectivement sur les grilles de commande de ces transistors d'une ligne de mot 13 choisie sont portés à un potentiel élevé, par exemple VPP. En conséquence ces transistors 16 et 15 sont passants et le potentiel VSENSE, nul , est appliqué sur les grilles de commande 6 des transistors à grille flottante des cellules mémoire.

Dans le même temps où les signaux WLi et Cj sont portés à VPP (ou au moins l'un deux si l'autre y était déjà), les signaux de pré-charge PRECH et de neutralisation CHEPR complémentaires sont inversés. La coupure du signal de pré-charge rend les transistors d'alimentation à VPP tels que 19 bloqués. L'alimentation VPP est alors découplée des lignes de bits. Par contre la mise en conduction des transistors tels que 17 par l'activation positive du signal CHEPR relie les lignes de bits telles que 11 aux sorties correspondantes 22 d'un registre 23. Le registre 23 contient les états de programmation LBi qu'il est nécessaire d'imposer dans les cellules mémoire correspondant à une des lignes de mot. Par exemple si la ligne de mot 13 est sélectionnée pour programmer les transistors tels que 3 des cellules mémoire, les autres lignes de mot telles que 24 sont désactivées, les signaux WLi qu'elles acheminent restent à zéro.

Deux cas peuvent se produire. Ou bien une sortie correspondante à une ligne de bits du registre 23 est portée à un niveau positif ou bien elle est portée à un potentiel nul. Si elle est portée à un potentiel nul la ligne de bits correspondante s'y décharge et les cellules mémoire 3 situées à l'intersection de cette ligne de bits et de la ligne de mot 13 sont programmées à un état donné, (par exemple à un état zéro, dépendant de la logique choisie : positive ou négative). Si par contre une sortie, par exemple la sortie 22 est portée à un potentiel positif, la ligne de bits 11 ne peut pas se décharger dans le registre 23 elle reste à un potentiel élevé. L'activation du transistor d'accès 9 par le signal de sélection de ligne de mot WLo appliqué sur la grille de commande 12 du transistor provoque l'application du potentiel VPP sur le drain 7 du transistor 3. Dans le même temps un potentiel intermédiaire AG est appliqué sur le drain de ce transistor à grille flottante 3, et sa grille de commande 6 est portée à un potentiel nul. Les conditions d'application d'un champ électrique important à l'endroit du pion d'amorçage 5 sont alors réunies. Les électrons quittent la grille flottante, provoquant l'instauration d'une concentration de charges positives piégées dans cette grille flottante. Le diagramme de la figure 3e montre ce qu'il advient du potentiel imposé sur la ligne de bits selon que cette ligne de bits avait ou non été sélectionnée : que l'on avait eu l'intention d'y programmer un état logique ou un autre.

Les cellules mémoire de type EEPROM ne peuvent pas en fait être programmées dans un état ou dans un autre quel que soit leur état antérieur. En effet, il est nécessaire pour obtenir une programmation correcte d'effacer préalablement le contenu de toutes les cellules à programmer puis de programmer dans l'état logique désiré celles qu'on veut particulièrement programmer. Pour l'opération d'effacement on profite du mode de page retenu pour la programmation proprement dite. L'effacement est obtenu en soumettant les grilles de commande 6 des transistors 3 à grille flottante des cellules mémoire à un potentiel élevé pendant que des potentiels nuls sont appliqués sur leur drain 7 et leur source 8. La figure 3 montre, préalablement à la pré-charge, cette opération d'effacement. Au cours de cette opération un potentiel élevé VSENSE est appliqué sur les grilles de commande 6, parce qu'au même instant les transistors 16 et 15 reçoivent sur leur grille de commande des signaux respectivement Cj et WLi portés eux aussi à VPP. L'application d'un potentiel nul sur les drains 7 est obtenu en appliquant une tension élevée CHEPR sur les grilles de commande 18 des transistor 17 de neutralisation. Ces transistors 17 sont alors passants et court-circuitent les lignes de bits avec les sorties portées à zéro du registre 23. Par ailleurs au même moment le signal AG appliqué sur les connexions de masse de réseau 14 est porté également à zéro. Dans ces conditions les charges électriques soumises à un champ électrique inverse réintègrent les grilles flottantes 4.

Le registre 23 comporte de préférence un jeu de bascules telles que la bascule 24 munies de deux inverseurs montés tête bêche respectivement 25 et 26. Pour l'opération d'effacement on impose préalablement un potentiel nul sur les lignes de bits. Ceci pourrait par exemple être obtenu en annulant simultanément les signaux CHEPR et VPP et en maintenant le signal PRECH à VCC. Ou bien tout simplement on fixe le signal PRECH à zéro et la ligne de bits se décharge à travers les cellules. Une fois que l'opération d'annulation a été exécutée, on peut , au moyen de signaux de programmation SP, provoquer le basculement sélectif des bascules dont on veut qu'elles changent d'état. Les signaux SP sont par exemple sélectivement appliqués sur des transistors tels que 28. Ces transistors sont en série dans des connexions d'entrée-sortie de la mémoire. Le signal Cj est appliqué sur les grilles 27 de ces transistors 28. La mise en condition des bascules est bien entendu effectuée avant l'opération de programmation.

Pour la programmation d'une ligne de mot suivante on réitère les mêmes opérations : on efface toutes les cellules mémoire reliées à la ligne de mot suivante, on repré-charge les mêmes lignes de bits que précédemment, et on programme les nouvelles cellules connectées à l'intersection de ces mêmes lignes de bits et de cette nouvelle ligne de mot. Ainsi de suite, la programmation peut être entreprise ligne de mot par ligne de mot. On constate avec l'invention un gain de temps à la programmation par rapport à l'état de la technique citée. On peut ne pas être obligé, ou ne pas vouloir, programmer tous les mots commandés par une même ligne de mot. Par exemple considérons qu'on a une ligne de mot qui commande 32 cellules et qu'un mot logique (utilisé par un microprocesseur) est de 8 bits. Si on ne veut programmer qu'un seul de ces mots, il suffit de sélectionner un signal Cj qui correspond à ce mot, qui est commun aux huit cellules. Les autres signaux Cj restent à zéro. on obtient ainsi l'effacement de huit cellules choisies uniquement. Pour la programmation, il suffit de mettre zéro dans les bascules qui sont attachées aux lignes de bits commandant les cellules à ne pas programmer. La figure 2 montre, en partie, dans le prolongement de la ligne de mot 13, un autre bloc mémoire 29 recevant le signal C1 pour valider la sélection d'un autre mot en série avec cette ligne de mot. L'accès aux cellules de cet autre mot peut se faire en dédoublant les sorties (dédoublement pointé par des flèches 30) du circuit de pré-charge 21.

## Revendications

1. Procédé de programmation des cellules (2) mémoire d'une mémoire (1), ces cellules comportant des transistors (3) à grille flottante (6) programmables par effet du champ électrique (5), procédé dans lequel
   – on sélectionne (11, 13) les cellules à programmer, puis
   – on programme (VSENSE) les cellules sélectionnées par application de potentiels de programmation,
   caractérisé en ce que
   – avant la programmation, on neutralise (CHEPR) la sélection des cellules en découplant les drains des transistors à grille flottante de tous les potentiels, et
   – on pré-charge (PRECH) les cellules en leur appliquant aux-dits drains certains (VPP) des potentiels de programmation, puis
   – on arrête la neutralisation, et
   – on programme (Wli) ces cellules en leur appliquant les autres potentiels de programmation.

2. Procédé selon la revendication 1 caractérisé en ce qu'on sélectionne des cellules reliées à une même ligne de mot (13).

3. Procédé selon la revendication 2 caractérisé en ce qu'on neutralise la sélection en ouvrant (18) des interrupteurs (17) de sélection placés chacun en série dans une (11) des lignes de bits aboutissant à une des cellules (2) reliées à cette ligne de mot (13).

4. Procédé selon l'une quelconque des revendications 1 à 3 caractérisé en ce qu'on arrête la neutralisation en découplant (19) la pré-charge, et en fermant les interrupteurs de sélection

5. Procédé selon l'une quelconque des revendications 1 à 4 caractérisé en ce qu'on pré-charge en appliquant un potentiel élevé sur les lignes de bits.

6. Procédé selon l'une quelconque des revendications 1 à 4 caractérisé en ce qu'on pré-charge en appliquant un potentiel faible sur la ligne de mot.

7. Procédé selon l'une quelconque des revendications 1 à 4 caractérisé en ce qu'on pré-charge en appliquant un potentiel intermédiaire sur une connexion de masse de réseau des cellules.

8. Procédé selon la revendication 6 caractérisé en ce qu'on efface en même temps plusieurs cellules appartenant à une même ligne de mot avant de les programmer.

9. Circuit de programmation des transistors (3) à grille flottante de cellules mémoire (2) d'une mémoire (1) comportant des moyens (21) pour appliquer des potentiels de programmation sur les bornes (6, 8) de ces transistors, caractérisé en ce qu'il comporte un circuit (17) de neutralisation de la sélection des cellules qui découple, avant la programmation, les drains des transistors à grille flottante de tous les potentiels, et un circuit (19) de pré-charge d'au moins un de ces potentiels de programmation sur les-dits drains pendant la période de neutralisation.

10. Circuit selon la revendication 9 caractérisé en ce qu'il comporte des moyens (17, 19) pour découpler le circuit de pré-charge (VPP) au moment de la programmation.

## Patentansprüche

1. Verfahren zum Programmieren von Speicherzellen (2) eines Speichers (I), wobei die Zellen Transistoren (3) mit schwebendem Gate (6) aufweisen, die durch die Wirkung eines elektrischen Feldes (5) programmierbar sind, wobei in dem Verfahren
   – die zu programmierenden Zellen ausgewählt (11, 13) werden, anschließend
   – die ausgewählten Zellen programmiert (VSENSE) werden, indem Programmierungspotentiale angelegt werden,
   dadurch gekennzeichnet, daß
   – vor der Programmierung die Auswahl der Zellen neutralisiert (CHEPR) wird, indem die Drains der Transistoren mit schwebendem Gate von sämtlichen Potentialen abgekoppelt werden, und
   – die Zellen vorgeladen (PRECH) werden, indem an die Drains bestimmte (VPP) der Programmierungspotentiale angelegt werden, anschließend
   – die Neutralisierung beendet wird und
   – diese Zellen programmiert (Wli) werden, indem an sie die anderen Programmierungspotentiale angelegt werden.

2. Verfahren gemäß Anspruch 1, dadurch gekennzeichnet, daß die Zellen ausgewählt werden, die mit derselben Wort-Leitung (13) verbunden sind.

3. Verfahren gemäß Anspruch 2, dadurch gekennzeichnet, daß die Auswahl dadurch neutralisiert wird, daß Auswahlunterbrecher (17) geöffnet (18) werden, die jeweils in Reihe in einer (11) der Bit-Leitungen, die an eine der mit dieser Wort-Leitung (13) verbundenen Zellen (2) führen, angeordnet sind.

4. Verfahren gemäß einem der Ansprüche 1 bis 3, dadurch gekennzeichnet, daß die Neutralisierung beendet wird, indem die Vorladung abgekoppelt (19) wird und die Auswahlunterbrecher geschlossen werden.

5. Verfahren gemäß einem der Ansprüche 1 bis 4, dadurch gekennzeichnet, daß die Vorladung durch Anlegen eines erhöhten Potentials an die Bit-Leitungen ausgeführt wird.

6. Verfahren gemäß einem der Ansprüche 1 bis 4, dadurch gekennzeichnet, daß die Vorladung durch Anlegen eines geringen Potentials an die Wort-Leitung ausgeführt wird.

7. Verfahren gemäß einem der Ansprüche 1 bis 4, dadurch gekennzeichnet, daß die Vorladung durch Anlegen eines mittleren Potentials an einen Masseanschluß des Zellengitters ausgeführt wird.

8. Verfahren gemäß Anspruch 6, dadurch gekennzeichnet, daß gleichzeitig mehrere Zellen, die zur selben Wort-Leitung gehören, gelöscht werden, bevor sie programmiert werden.

9. Schaltung zum Programmieren von Speicherzellen (2) eines Speichers (1) zugeordneten Transistoren (3) mit schwebendem Gate, mit Mitteln (21) zum Anlegen von Programmierungspotentialen an die Anschlüsse (6, 8) dieser Transistoren, dadurch gekennzeichnet, daß sie eine Schaltung (17) zum Neutralisieren der Auswahl der Zellen aufweist, die vor der Programmierung die Drains der Transistoren mit schwebendem Gate von sämtlichen Potentialen abkoppelt, und eine Schaltung (19) zum Vorladen der Drains mit wenigstens einem dieser Programmierungspotentiale während des Neutralisierungs-Intervalls aufweist.

10. Schaltung gemäß Anspruch 9, dadurch gekennzeichnet, daß sie Mittel (17, 19) zum Abkoppeln der Vorladeschaltung (VPP) zum Zeitpunkt der Programmierung aufweist.

## Claims

1. A method for programming the storage cells (2) of a memory (1), said cells comprising floating gate (6) transistors (3) able to be programmed by the effect of an electric field (5), in which method:
   – the cells to be programmed are selected (11 and 13), then
   – the selected cells are programmed (VSENSE) by the application of programming electric potentials,
   characterized in that
   – prior to the programming step, the selection of the cells is neutralized (CHEPR) by decoupling the drains of the floating gate transistors from all the potentials,
   – the cells are pre-charged (PRECH) by the application to them at the said drains of some (VPP) of the programming potentials, then
   – the neutralization is halted and
   – the cells are programmed (Wli) by the application to them of the other programming potentials.

2. The method as claimed in claim 1, characterized in that the cells connected with one and the same word line (13) are selected.

3. The method as claimed in claim 2, characterized in that the selection is neutralized by turning off (18) selection switches (17) each placed in series in one (11) of the bit lines leading to one of the cells (2) connected with each word line (13).

4. The method as claimed in any one of the preceding claims 1 through 3, characterized in that the neutralization is halted by decoupling (19) the precharge and turning on the selection switches.

5. The method as claimed in any one of the preceding claims 1 through 4, characterized in that said pre-charging is performed by the application of a raised potential to the bit lines.

6. The method as claimed in any one of the preceding claims 1 through 4, characterized in that said pre-charging is performed by the application of a weak potential to the word line.

7. The method as claimed in any one of the preceding claims 1 through 4, characterized in that said pre-charging is performed by the application of an intermediate potential to a ground connection of the cell network.

8. The method as claimed in claim 6, characterized in that simultaneously a plurality of cells belonging to a given word line are erased prior to programming same.

9. A circuit for programming floating gate storage transistors (3) of a memory (1) comprising means (21) for the application of programming potentials to the terminals (6 and 8) of the said transistors, characterized in that it comprises a circuit (17) for the neutralization of the selection of the cells which prior to programming decouples the drains of the floating gate transistors from all the potentials, and a circuit (19) for the pre-charging of at least one of the said programming potentials at the said drains during the neutralization time.

10. The circuit as claimed in claim 9, characterized in that it comprises means (17 and 19) in order to decouple the pre-charge circuit (VPP) at the instant of programming.

# FIG_1

FIG_2

# FIG_3